# EUROPEAN PATENT SPECIFICATION

(11) **EP 3 958 092 B1**
(45) Date of publication and mention of the grant of the patent: **28.10.2026**
(21) Application number: 21185613.3
(22) Date of filing: 14.07.2021
(51) Int. Cl.: G06F 1/16, G09F 9/30, H04M 1/02

(54) **DISPLAY DEVICE**
ANZEIGEVORRICHTUNG
DISPOSITIF D'AFFICHAGE

(30) Priority: 21.08.2020 KR 20200105639; 29.10.2020 KR 20200142140
(43) Date of publication of application: 23.02.2022
(73) Proprietor: Samsung Display Co., Ltd., Gyeonggi-do 17113 (KR)
(72) Inventor: Kim, Se Bong, Tangjeongmyeon, Asan-si 303-701 (KR)
(74) Representative: Dr. Weitzel & Partner

(56) References cited:
- EP-A1- 3 771 186
- WO-A1-2021/107729
- US-A1- 2015 043 174
- US-A1- 2015 366 089
- US-A1- 2018 146 560
- US-A1- 2019 174 645
- US-A1- 2019 196 548
- US-A1- 2019 346 887
- US-A1- 2020 209 998
- US-A1- 2020 260 603

## Description

### BACKGROUND

### 1. Technical Field

The invention relates to a display device with improved reliability.

### 2. Description of the Related Art

A display device may display a variety of images through a display screen to provide a user with information. In general, the display device may display the information in the display screen allocated thereto. Recent years have seen development of flexible display devices including a flexible display panel that may be folded. Different from a rigid display device, the flexible display device may be folded, rolled, or bent. Since the shape of the flexible display device may be changed in various ways, the flexible display device may be carriable regardless of its original screen size, and thus, user convenience may be improved.

It is to be understood that this background of the technology section is, in part, intended to provide useful background for understanding the technology. However, this background of the technology section may also include ideas, concepts, or recognitions that were not part of what was known or appreciated by those skilled in the pertinent art prior to a corresponding effective filing date of the subject matter disclosed herein.

Reference is made to US 2020/209998 A1 and US 2020/260603 A1.

### SUMMARY

The invention provides a display device that may have improved product reliability.

The invention is defined by independent claim 1.

Each of the first groove and the second groove may extend in a second direction intersecting the first direction.

The first groove may be defined in the first lower surface, and the second groove may be defined in the second lower surface.

The first groove may be defined in the first upper surface, and the second groove may be defined in the second upper surface.

The display device may further include a first compensation member disposed in the first groove and a second compensation member disposed in the second groove.

Each of the first compensation member and the second compensation member may have an elastic modulus smaller than an elastic modulus of each of the first plate and the second plate.

The display device may further include a folding set disposed under the first plate and the second plate. The folding set may include a first body disposed under the first area, a second body disposed under the third area, and a support frame disposed under the second area. The support frame may be disposed between the first plate and the second plate and may support a lower portion of the display panel in case that the second area of the display panel is unfolded, and the support frame may be spaced apart from the display panel in case that the display panel is folded.

The folding set may further include a first wing plate rotatably coupled to the first body and a second wing plate rotatably coupled to the second body.

The support frame may include a portion having a width smaller than a distance in the first direction between the first wing plate and the second wing plate.

A first curvable portion, a second curvable portion, and a third curvable portion may be defined in the second area, the first curvable portion and the third curvable portion may be spaced apart from each other, the second curvable portion being disposed between the first curvable portion and the third curvable portion, the first curvable portion may overlap the first groove, and the third curvable portion may overlap the second groove.

The first curvable portion and the third curvable portion may be curved in a direction opposite to a direction in which the second curvable portion may be curved.

The second curvable portion may overlap a gap between the first plate and the second plate.

A portion of the display panel, which may not be supported by the first and second plates, may be supported by the support frame, the first compensation member may be disposed in the first groove, and the second compensation member may be disposed in the second groove. Thus, the first and third curvable portions may be prevented from sagging downward.

### BRIEF DESCRIPTION OF THE DRAWINGS

The above and other advantages of the invention will become readily apparent by reference to the following detailed description when considered in conjunction with the accompanying drawings wherein:
FIG. 1 is a perspective view schematically showing a display device according to an embodiment of the invention;
FIG. 2 is a perspective view schematically showing a folded state of the display device shown in FIG. 1;
FIG. 3 is a plan view schematically showing a display device according to an embodiment of the invention;
FIG. 4 is an exploded perspective view schematically showing a display device according to an embodiment of the invention;
FIG. 5 is a cross-sectional view schematically showing a display module according to an embodiment of the invention;
FIG. 6 is a cross-sectional view schematically showing a display panel according to an embodiment of the invention;
FIG. 7 is a plan view schematically showing a display panel according to an embodiment of the invention;
FIG. 8A is a schematic cross-sectional view taken along line I-I' of FIG. 3;
FIG. 8B is a cross-sectional view schematically showing a folded state of a portion shown in FIG. 8A;
FIG. 8C is a cross-sectional view schematically showing a folded state of a portion shown in FIG. 8A;
FIG. 9A is an enlarged cross-sectional view schematically showing portion AA1 shown in FIG. 8A according to an embodiment of the invention;
FIG. 9B is an enlarged cross-sectional view schematically showing portion AA1 shown in FIG. 8A according to an embodiment of the invention;
FIG. 9C is an enlarged cross-sectional view schematically showing portion AA1 shown in FIG. 8A according to an embodiment of the invention;
FIG. 10 is an enlarged cross-sectional view schematically showing portion AA2 shown in FIG. 8C according to an embodiment of the invention;
FIG. 11 is a rear view schematically showing a first plate and a second plate according to an embodiment of the invention;
FIG. 12 is a rear view schematically showing a first plate and a second plate according to an embodiment of the invention;
FIG. 13 is a cross-sectional view schematically showing a display module according to an embodiment of the invention; and
FIG. 14 is a cross-sectional view schematically showing a display module according to an embodiment of the invention.

### DETAILED DESCRIPTION OF THE EMBODIMENTS

Hereinafter, the invention will be explained in detail with reference to the accompanying drawings.

In the invention, it will be understood that when an element or layer is referred to as being "on", "connected to" or "coupled to" another element or layer, it can be directly on, connected or coupled to the other element or layer or intervening elements or layers may be present.

Like reference characters refer to like elements throughout. In the drawings, the thickness, ratio, and dimension of components may be exaggerated for effective description of the technical content.

As used herein, the term "and/or" includes any and all combinations of one or more of the associated listed items. For example, "A and/or B" may be understood to mean "A, B, or A and B." The terms "and" and "or" may be used in the conjunctive or disjunctive sense and may be understood to be equivalent to "and/or."

It will be understood that, although the terms first, second, etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, a first element, component, region, layer or section discussed below could be termed a second element, component, region, layer or section without departing from the teachings of the invention. As used herein, the singular forms, "a", "an" and "the" are intended to include the plural forms as well (and vice versa), unless the context clearly indicates otherwise.

Spatially relative terms, such as "beneath", "below", "lower", "above", "upper" and the like, may be used herein for ease of description to describe one element or feature's relationship to another element(s) or feature(s) as illustrated in the figures.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

It will be further understood that the terms "comprises", "comprising", "has", "having", "includes", "including" or the like, when used in this specification, specify the presence of stated features, integers, steps, operations, elements, and/or components, but do not preclude the presence or addition of one or more other features, integers, steps, operations, elements, components, and/or groups thereof.

In the specification and the claims, the phrase "at least one of" is intended to include the meaning of "at least one selected from the group of" for the purpose of its meaning and interpretation. For example, "at least one of A and B" may be understood to mean "A, B, or A and B."

The terms "overlap" or "overlapped" mean that a first object may be above or below or to a side of a second object, and vice versa. Additionally, the term "overlap" may include layer, stack, face or facing, extending over, covering, or partly covering or any other suitable term as would be appreciated and understood by those of ordinary skill in the art.

The terms "face" and "facing" mean that a first element may directly or indirectly oppose a second element. In a case in which a third element intervenes between the first and second element, the first and second element may be understood as being indirectly opposed to one another, although still facing each other.

"About", "substantially", "approximately", and the like, as used herein are inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value.

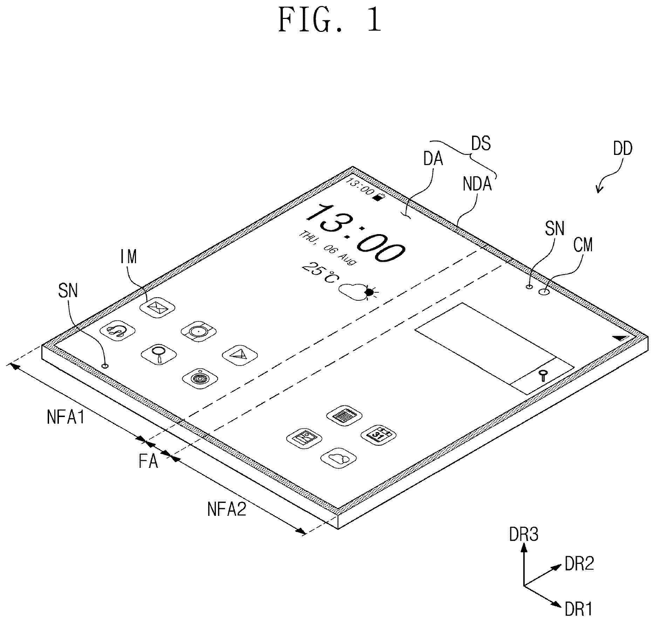

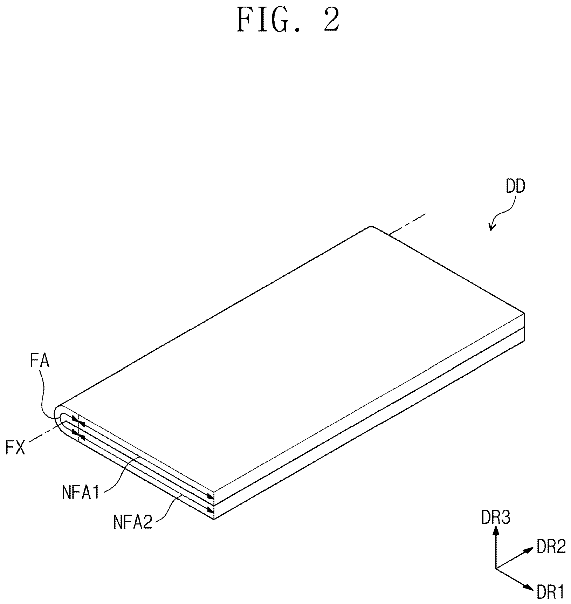

FIG. 1 is a perspective view schematically showing a display device DD according to an embodiment of the invention, and FIG. 2 is a perspective view schematically showing the display device DD shown in FIG. 1 in a folded state.

Referring to FIGS. 1 and 2, the display device DD may include a display surface DS defined by a first direction DR1 and a second direction DR2 intersecting the first direction DR1. The display device DD may provide an image IM to a user through the display surface DS.

The display device DD may include a display area DA and a non-display area NDA around the display area DA. The display area DA may display the image IM, and the non-display area NDA may not display the image IM. The non-display area NDA may surround the display area DA, however, embodiments are not limited thereto or thereby, and the shape of the display area DA and the shape of the non-display area NDA may be changed.

A direction substantially perpendicular to a plane defined by the first direction DR1 and the second direction DR2 may be referred to as a "third direction DR3". In the invention, the expression "in a plan view" may mean a state of being viewed in a direction (e.g.,, in the third direction DR3). Hereinafter, the first, second, and third directions DR1, DR2, and DR3 may be indicated by first, second, and third directional axes, respectively, and are assigned with the same reference numerals as those of the first, second, and third directional axes.

The display device DD may include a folding area FA and non-folding areas NFA1 and NFA2. The non-folding areas NFA1 and NFA2 may include a first non-folding area NFA1 and a second non-folding area NFA2. The folding area FA may be disposed between the first non-folding area NFA1 and the second non-folding area NFA2. The first non-folding area NFA1, the folding area FA, and the second non-folding area NFA2 may be sequentially defined in the display device DD along the first direction DR1.

In FIG. 1, one folding area FA and two non-folding areas NFA1 and NFA2 are shown as a representative example, however, the number of the folding areas FA and the number of non-folding areas NFA1 and NFA2 should not be limited thereto or thereby. For example, the display device DD may include more than two non-folding areas NFA1 and NFA2 and folding areas FA disposed between the non-folding areas.

The display device DD may include sensors SN and at least one camera CM. As an example, the sensors SN may include a proximity and brightness sensor, however, they should not be limited thereto or thereby. The camera CM may photograph an image of an external object. The sensors SN and the camera CM may be disposed in the display area DA adjacent to the non-display area NDA. The sensors SN and the camera CM may be disposed in the first non-folding area NFA1 or the second non-folding area NFA2. In an embodiment of the invention, the sensors SN and the camera CM may be omitted.

Referring to FIG. 2, the display device DD is a foldable display device DD that may be folded and unfolded. For example, the folding area FA may be folded with respect to a folding axis FX substantially parallel to the second direction DR2, and thus, the display device DD may be folded. The folding axis FX may be defined as an axis (e.g., major axis) substantially parallel to long sides of the display device DD, however, it should not be particularly limited.

In case that the display device DD is folded, the display device DD may be inwardly folded (in-folding) such that the first non-folding area NFA1 and the second non-folding area NFA2 face each other and the display surface DS may not be exposed to the outside.

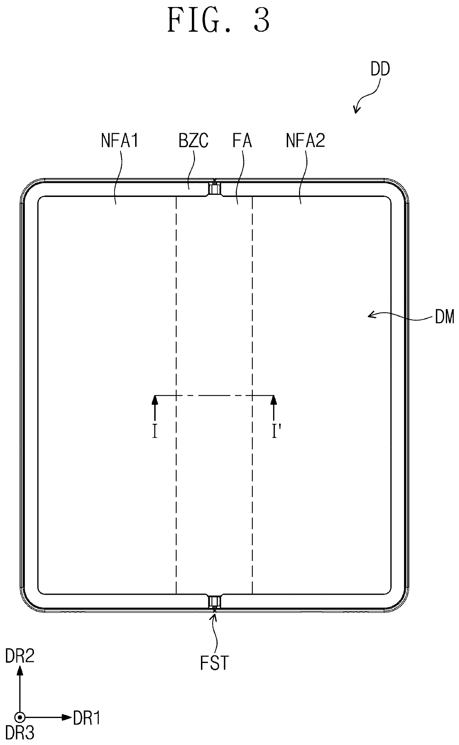

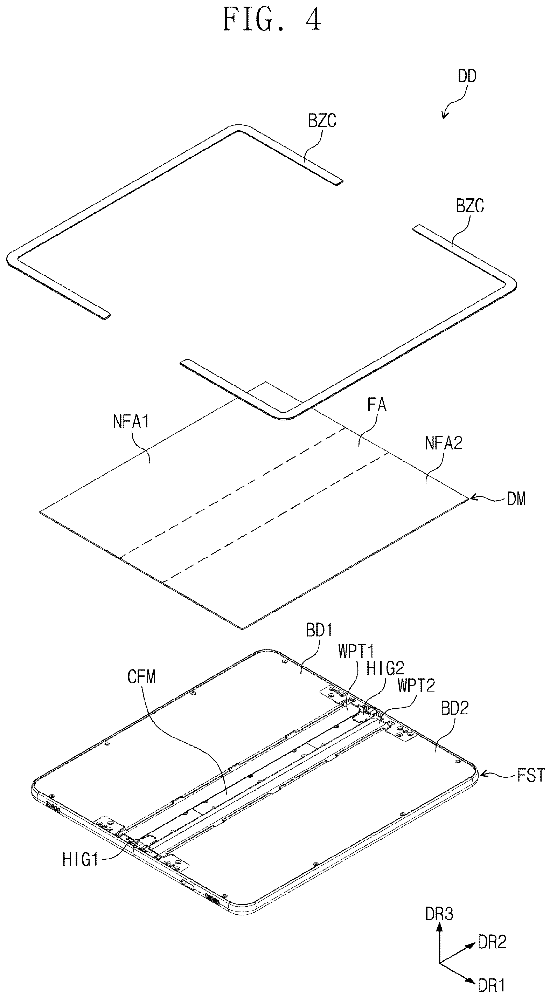

FIG. 3 is a plan view schematically showing the display device DD according to an embodiment of the invention, and FIG. 4 is an exploded perspective view schematically showing the display device DD according to an embodiment of the invention.

Referring to FIGS. 3 and 4, the display device DD may include a display module DM, a bezel cover BZC disposed on an edge of the display module DM, and a folding set FST disposed under the display module DM and the bezel cover BZC.

The bezel cover BZC may be disposed around the first and second non-folding areas NFA1 and NFA2 of the display module DM. The bezel cover BZC may be disposed to surround the first and second non-folding areas NFA1 and NFA2 of the display module DM. The bezel cover BZC may have a black color, however, the color of the bezel cover BZC should not be limited to the black color. The non-display area NDA of the display device DD shown in FIG. 1 may overlap the bezel cover BZC.

The folding set FST may be disposed under the display module DM and the bezel cover BZC and may support the display module DM and the bezel cover BZC. The display module DM and the bezel cover BZC may be attached to the folding set FST by an adhesive. The folding set FST may be folded with respect to two folding axes substantially parallel to the second direction DR2 and overlapping the folding area FA in a plan view, and thus, the display module DM may be folded.

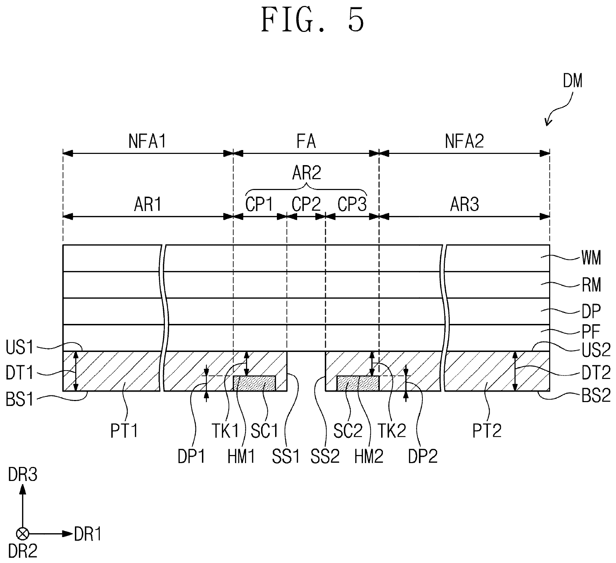

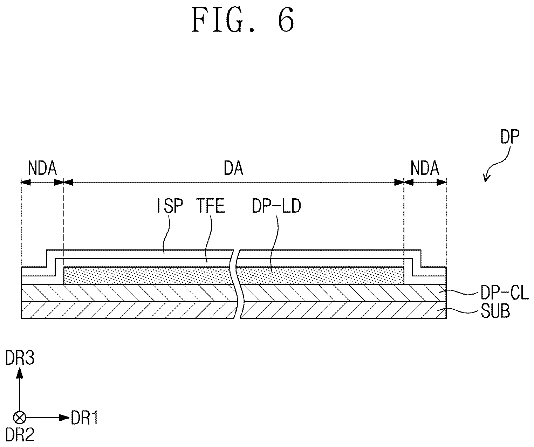

FIG. 5 is a cross-sectional view schematically showing a display module DM according to an embodiment of the invention, and FIG. 6 is a cross-sectional view schematically showing a display panel DP according to an embodiment of the invention.

Referring to FIG. 5, the display module DM may include a window module WM, an anti-reflective layer RM, a display panel DP, a protective film PF, a first plate PT1, and a second plate PT2.

The window module WM may provide a front surface of the display device DD (refer to FIG. 1). The window module WM may include a thin film glass substrate, a plastic film disposed on the thin film glass substrate, and an adhesive layer attaching the thin film glass substrate to the plastic film. The adhesive layer may be a transparent adhesive layer, such as a pressure sensitive adhesive (PSA) film, an optically clear adhesive (OCA) film, or an optically clear resin (OCR) film.

The thin film glass substrate may be a chemically strengthened glass. As the thin film glass substrate may be applied, a crease may be reduced even though the window module WM may be repeatedly folded and unfolded. In an embodiment, not the thin film glass substrate but a synthetic resin film may be applied to the window module WM. The plastic film may include polyimide, polycarbonate, polyamide, triacetylcellulose, polymethylmethacrylate, polyethylene terephthalate, or a combination thereof. Although not shown in figures, at least one of a hard coating layer, an anti-fingerprint layer, and an anti-reflective layer may be disposed on an upper surface of the plastic film.

The anti-reflective layer RM may be disposed under the window module WM. The anti-reflective layer RM may reduce a reflectance of an external light incident thereto from outside of the display device DD (refer to FIG. 1).

The anti-reflective layer RM may be formed on the display panel DP through successive processes. The anti-reflective layer RM may include color filters. The color filters may have a predetermine arrangement. For example, the color filters may be arranged by taking into account emission colors of pixels included in the display panel DP. The anti-reflective layer RM may further include a black matrix adjacent to the color filters.

The anti-reflective layer RM may include a polarizing film, and the polarizing film may include a retarder and/or a polarizer. Although not shown in figures, the anti-reflective layer RM may be coupled to each of the display panel DP and the window module WM by adhesive layers.

Referring to FIGS. 5 and 6, the display panel DP may be disposed under the anti-reflective layer RM. The display panel DP may include a base layer SUB, a circuit layer DP-CL, a light emitting element layer DP-LD, an encapsulation layer TFE, and a sensor layer ISP.

The base layer SUB may have a multi-layer structure. For example, the base layer SUB may include a first synthetic resin layer, a silicon oxide (SiOₓ) layer disposed on the first synthetic resin layer, an amorphous silicon (a-Si) layer disposed on the silicon oxide layer, and a second synthetic resin layer disposed on the amorphous silicon layer. The silicon oxide layer and the amorphous silicon layer may be referred to as a base barrier layer.

Each of the first and second synthetic resin layers may include a polyimide-based resin. Each of the first and second synthetic resin layers may include at least one of an acrylate-based resin, a methacrylate-based resin, a polyisoprene-based resin, a vinyl-based resin, an epoxy-based resin, a urethane-based resin, a cellulose-based resin, a siloxane-based resin, a polyamide-based resin, and a perylene-based resin. In the invention, the term "Abased resin" may mean that a functional group of "A" may be included.

The circuit layer DP-CL may be disposed on the base layer SUB. The circuit layer DP-CL may include an insulating layer, a semiconductor pattern, a conductive pattern, and a signal line. The insulating layer, a semiconductor layer, and a conductive layer may be formed on the base layer SUB by a coating or depositing process. The insulating layer, the semiconductor layer, and the conductive layer may be selectively patterned by photolithography processes. The semiconductor pattern, the conductive pattern, and the signal line included in the circuit layer DP-CL may be formed.

The light emitting element layer DP-LD may be disposed on the circuit layer DP-CL. The light emitting element layer DP-LD may include a light emitting element. For example, the light emitting element layer DP-LD may include at least one of an organic light emitting material, a quantum dot, a quantum rod, a micro-LED, and a nano-LED.

The encapsulation layer TFE may be disposed on the light emitting element layer DP-LD. The encapsulation layer TFE may protect the light emitting element layer DP-LD from moisture, oxygen, and a foreign substance such as dust particles.

The sensor layer ISP may be disposed on the encapsulation layer TFE. The sensor layer ISP may sense an external input applied thereto from the outside. For example, the external input may be a user input. The user input may include a variety of external inputs, such as a part of user's body, light, heat, pen, or pressure.

The sensor layer ISP may be formed on the encapsulation layer TFE through successive processes. In this case, it may be expressed that the sensor layer ISP may be disposed directly on the encapsulation layer TFE. The expression that a component "B" may be disposed directly on a component "A" may mean that no intervening elements may be present between the component "B" and the component "A". For example, a separate adhesive member may not be disposed between the sensor layer ISP and the encapsulation layer TFE. In other embodiments, the sensor layer ISP may be combined with the encapsulation layer TFE by an adhesive member. The adhesive member may include an ordinary adhesive.

Referring to FIG. 5, a first area AR1, a second area AR2 that may be folded and unfolded, and a third area AR3 may be sequentially defined in the display panel DP along the first direction DR1. The first area AR1 may overlap the first non-folding area NFA1, the second area AR2 may overlap the folding area FA, and the third area AR3 may overlap the second non-folding area NFA2. The first, second, and third areas AR1, AR2, and AR3 of the display panel DP may be described as first, second, and third areas AR1, AR2, and AR3 of the display module DM.

The protective film PF may be disposed under the display panel DP. The protective film PF may protect a lower portion of the display panel DP. The protective film PF may include a flexible plastic material. The protective film PF may prevent scratches from occurring on a rear surface of the display panel DP during a manufacturing process of the display panel DP. The protective film PF may be a colored polyimide film. For example, the protective film PF may be an opaque yellow film, however, embodiments are not limited thereto or thereby.

The first plate PT1 is disposed under the display panel DP. For example, the first plate PT1 may be disposed under the protective film PF. The first plate PT1 and the second plate PT2 support the display panel DP.

The first plate PT1 overlaps the first area AR1 and a portion of the second area AR2. The second plate PT2 is disposed under the display panel DP. For example, the second plate PT2 may be disposed under the protective film PF. The second plate PT2 overlaps the third area AR3 and another portion of the second area AR2. The first plate PT1 and the second plate PT2 are spaced apart from each other in the first direction DR1. A gap between the first plate PT1 and the second plate PT2 overlaps the second area AR2.

The first plate PT1 and the second plate PT2 may include a material having an elastic modulus equal to or greater than about 60 GPa. The first plate PT1 and the second plate PT2 may include a metal material such as a stainless steel. For example, the first plate PT1 and the second plate PT2 may include SUS 304, however, embodiments are not limited thereto or thereby. The first plate PT1 and the second plate PT2 may include a variety of metal materials.

In other embodiments, the first plate PT1 and the second plate PT2 may include a non-metallic material. For example, each of the first plate PT1 and the second plate PT2 may include a glass substrate or a plastic substrate. For example, the plastic substrate may include polyethylene (PE), however, embodiments are not particularly limited.

A first groove HM1 is defined in the first plate PT1, and a second groove HM2 is defined in the second plate PT2. Each of the first groove HM1 and the second groove HM2 overlaps the second area AR2.

The first plate PT1 includes a first upper surface US1, a first lower surface BS1, and a first side surface SS1, and the second plate PT2 includes a second upper surface US2, a second lower surface BS2, and a second side surface SS2. The first lower surface BS1 is spaced apart from the display panel DP with the first upper surface US1 disposed therebetween, and the second lower surface BS2 is spaced apart from the display panel DP with the second upper surface US2 disposed therebetween. The first side surface SS1 extends to the first upper surface US1 and the first lower surface BS1, and the second side surface SS2 extends to the second upper surface US2 and the second lower surface BS2. The first side surface SS1 faces the second plate PT2, and the second side surface SS2 faces the first plate PT1.

The first groove HM1 is defined in the first lower surface BS1, and the second groove HM2 is defined in the second lower surface BS2. The first groove HM1 has a depth DP1 smaller than a maximum distance DT1 between the first upper surface US1 and the first lower surface BS1, and the second groove HM2 has a depth DP2 smaller than a maximum distance DT2 between the second upper surface US2 and the second lower surface BS2.

A first thickness TK1 of the first plate PT1 in a portion where the first groove HM1 may be defined may be smaller than a thickness of another portion, for example, the maximum distance DT1. A second thickness TK2 of the second plate PT2 in a portion where the second groove HM2 may be defined may be smaller than the thickness of another portion, for example, the maximum distance DT2. Each of the first thickness TK1 and the second thickness TK2 may have a thickness that may be enough to prevent a crack and a plastic deformation. For example, each of the first thickness TK1 and the second thickness TK2 may be equal to or smaller than about 40 micrometers, however, embodiments are not particularly limited.

A first compensation member SC1 may be disposed in the first groove HM1, and a second compensation member SC2 may be disposed in the second groove HM2. Each of the first compensation member SC1 and the second compensation member SC2 may have an elastic modulus smaller than an elastic modulus of each of the first plate PT1 and the second plate PT2. For example, the first compensation member SC1 and the second compensation member SC2 may include silicon or adhesive.

As the first compensation member SC1 and the second compensation member SC2 may be respectively disposed in the first groove HM1 and the second groove HM2, a phenomenon in which the display panel DP may be sagged downward may be prevented in areas where the first groove HM1 and the second groove HM2 may be defined.

Although not shown in figures, lower members may be further disposed under the first plate PT1 and the second plate PT2. For example, the lower members may include a heat dissipation layer having a high heat conductivity and a cushion layer having an elastic modulus smaller than that of the first plate PT1 and the second plate PT2. The lower members may further include an adhesive layer to attach components to each other. The heat dissipation layer may include a metal or metal alloy. For instance, the heat dissipation layer may include a copper, a copper alloy, or graphite. The cushion layer may include a foam sheet having a predetermined elastic force. For example, the cushion layer may include a sponge or polyurethane.

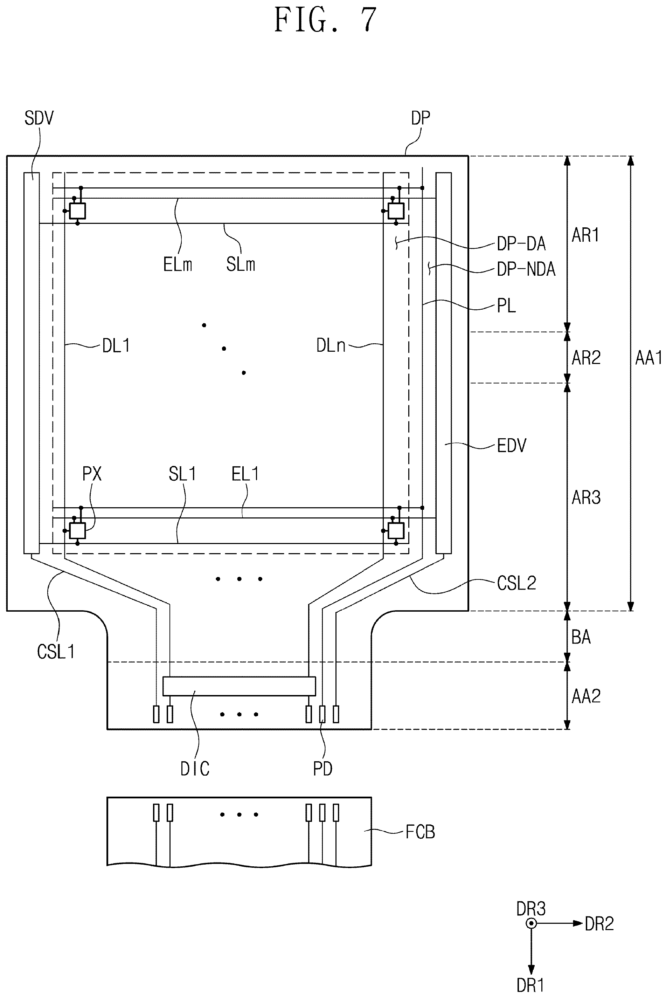

FIG. 7 is a plan view schematically showing a display panel DP according to an embodiment of the invention.

Referring to FIG. 7, the display panel DP may include a display area DP-DA and a non-display area DP-NDA around the display area DP-DA. The display area DP-DA and the non-display area DP-NDA may be distinct from each other by the presence or absence of a pixel PX. The pixel PX may be disposed in the display area DP-DA. A scan driver SDV, a data driver, and an emission driver EDV may be disposed in the non-display area DP-NDA. The data driver may be a circuit provided in a driving chip DIC.

The display panel DP includes a first panel area AA1, a second panel area AA2, and a bending area BA, which are distinct from each other in the first direction DR1. The second panel area AA2 and the bending area BA may be areas of the non-display area DP-NDA. The bending area BA may be defined between the first panel area AA1 and the second panel area AA2.

The first panel area AA1 may correspond to the display surface DS of FIG. 1. The first area AR1, the second area AR2, and the third area AR3 may be defined in the first panel area AA1. The first area AR1, the second area AR2, and the third area AR3 may correspond to the first non-folding area NFA1, the folding area FA, and the second non-folding area NFA2 of FIG. 1, respectively.

A length or width in the second direction DR2 of the bending area BA and the second panel area AA2 may be smaller than a length or width in the second direction DR2 of the first panel area AA1. An area having a relatively short length in a bending axis direction may be relatively easily bent.

The display panel DP may include pixels PX, scan lines SL1-SLm, data lines DL1 to DLn, emission lines EL1 to ELm, first and second control lines CSL1 and CSL2, a power line PL, and pads PD. In an embodiment, each of "m" and "n" may be a natural number. The pixels PX may be electrically connected to the scan lines SL1 to SLm, the data lines DL1 to DLn, and the emission lines EL1 to ELm.

The scan lines SL1 to SLm may extend in the second direction DR2 and may be electrically connected to the scan driver SDV. The data lines DL1 to DLn may extend in the first direction DR1 and may be electrically connected to the driving chip DIC via the bending area BA. The emission lines EL1 to ELm may extend in the second direction DR2 and may be electrically connected to the emission driver EDV.

The power line PL may include a portion extending in the first direction DR1 and a portion extending in the second direction DR2. The portion extending in the second direction DR2 and the portion extending in the first direction DR1 may be disposed on different layers from each other. The portion of the power line PL, which extends in the first direction DR1, may extend to the second panel area AA2 via the bending area BA. The power line PL may provide a first voltage to the pixels PX.

The first control line CSL1 may be electrically connected to the scan driver SDV and may extend to a lower end of the second panel area AA2 via the bending area BA. The second control line CSL2 may be electrically connected to the emission driver EDV and may extend to the lower end of the second panel area AA2 via the bending area BA.

In a plan view, the pads PD may be disposed adjacent to the lower end of the second panel area AA2. The driving chip DIC, the power line PL, the first control line CSL1, and the second control line CSL2 may be electrically connected to the pads PD. A flexible circuit film FCB may be electrically connected to the pads PD through an anisotropic conductive adhesive layer.

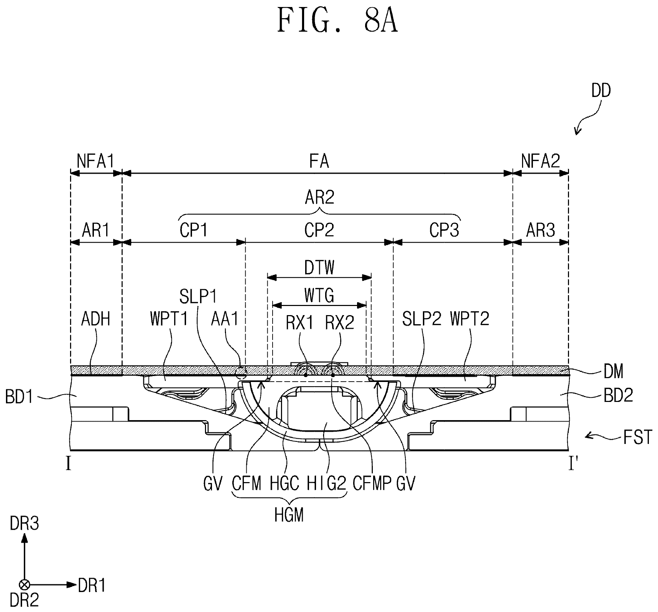

FIG. 8A is a schematic cross-sectional view taken along line I-I' shown in FIG. 3.

Referring to FIGS. 3, 4, and 8A, the display module DM may be coupled to the folding set FST. The folding set FST may be disposed under the first plate PT1 (refer to FIG. 5) and the second plate PT2 (refer to FIG. 5).

The folding set FST may include a first body BD1, a second body BD2, a hinge module HGM, a first wing plate WPT1, and a second wing plate WPT2.

The first body BD1 may be disposed under the first area AR1, and the second body BD2 may be disposed under the third area AR3. The first body BD1 and the second body BD2 may be spaced apart from each other in the first direction DR1. The first body BD1 may be symmetrical with the second body BD2 with respect to the second direction DR2, however, embodiments are not particularly limited.

The first body BD1 may include a first inclined surface SLP1, and the second body BD2 may include a second inclined surface SLP2. The first inclined surface SLP1 and the second inclined surface SLP2 may be respectively provided as portions of the first body BD1 and the second body BD2, which may overlap the second area AR2.

The first wing plate WPT1 may be disposed on the first body BD1 and may be rotatably coupled to the first body BD1. The second wing plate WPT2 may be disposed on the second body BD2 and may be rotatably coupled to the second body BD2. The first wing plate WPT1 may be disposed on the first inclined surface SLP1, and the second wing plate WPT2 may be disposed on the second inclined surface SLP2.

The hinge module HGM may be disposed between the first body BD1 and the second body BD2. The hinge module HGM may be coupled to the first body BD1 and the second body BD2. The hinge module HGM may provide rotation axes RX1 and RX2. Each of the rotation axes RX1 and RX2 may extend in the second direction DR2. The rotation axes RX1 and RX2 may include a first rotation axis RX1 and a second rotation axis RX2 spaced apart from the first rotation axis RX1 in the first direction DR1. The rotation axes RX1 and RX2 may define the folding axis FX shown in FIG. 2.

The hinge module HGM may include a first hinge HIG1, a second hinge HIG2, a support frame CFM, and a hinge cover HGC. Each of the first hinge HIG1 and the second hinge HIG2 may be disposed between the first body BD1 and the second body BD2 and may be extended to the first body BD1 and the second body BD2.

The support frame CFM may extend in the second direction DR2 and may be disposed between the first hinge HIG1 and the second hinge HIG2. The support frame CFM may be disposed between the first body BD1 and the second body BD2. The support frame CFM may be disposed between the first wing plate WPT1 and the second wing plate WPT2.

Grooves GV may be defined in upper portions of both sides of the support frame CFM. Each of the grooves GV may extend in the second direction DR2. In case that the hinge module HGM is extended to the first and second bodies BD1 and BD2, one side of the first wing plate WPT1 and one side of the second wing plate WPT2, which face each other, may be disposed in the grooves GV, respectively.

In case that the display device DD is in an unfolded state, the first wing plate WPT1 and the second wing plate WPT2 may be spaced apart from each other by a predetermined distance DTW. A width WTG in the first direction DR1 of a portion CFMP of the support frame CFM may be smaller than the predetermined distance DTW.

In case that the display device DD is in an unfolded state, the support frame CFM may be in contact with the display module DM and may support the display module DM. For example, the portion CFMP of the support frame CFM may support portions of the display module DM, which may not be supported by the first plate PT1 and the second plate PT2 shown in FIG. 5. In case that the display device DD is in the unfolded state, the portions of the display module DM, which may not be supported by the first plate PT1 and the second plate PT2 may be supported by the support frame CFM, and thus, a phenomenon in which a certain area of the display module DM is sagged downward may be prevented.

The hinge cover HGC may be disposed under the first hinge HIG1, the second hinge HIG2, and the support frame CFM. The first hinge HIG1, the second hinge HIG2, and the support frame CFM may be extended to the hinge cover HGC.

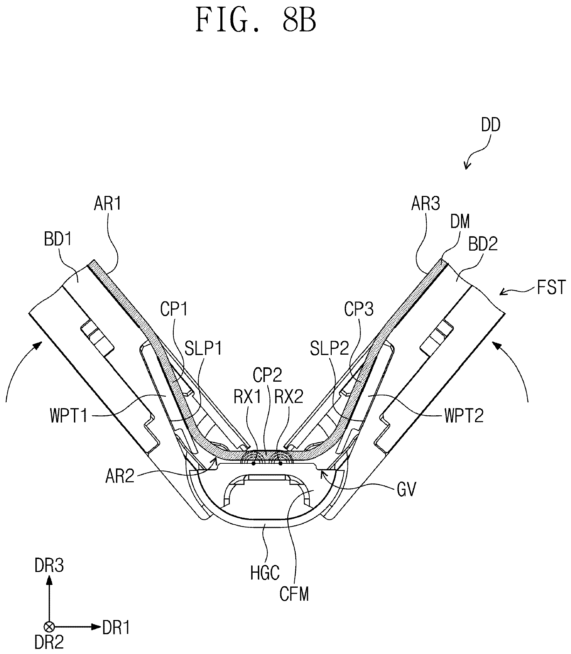

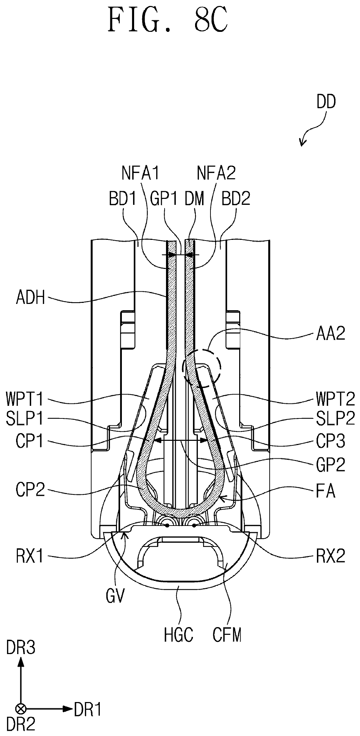

FIG. 8B is a cross-sectional view schematically showing a folded state of the portion shown in FIG. 8A, and FIG. 8C is a cross-sectional view schematically showing a folded state of the portion shown in FIG. 8A.

Referring to FIGS. 8A, 8B, and 8C, the folding set FST may be folded with respect to the first and second rotation axes RX1 and RX2, and the display module DM may be folded. The second area AR2 may be bent, and the display module DM may be folded. The display module DM may be inwardly folded (in-folding) such that the first area AR1 and the third area AR3 may face each other.

A first curvable portion CP1, a second curvable portion CP2, and a third curvable portion CP3 may be defined in the second area AR2. The first curvable portion CP1 and the third curvable portion CP3 may be spaced apart from each other with the second curvable portion CP2 interposed therebetween. In case that the display device DD is folded, the first curvable portion CP1 and the third curvable portion CP3 may be curved in a direction opposite to a direction in which the second curvable portion CP2 may be curved. For example, in case that the display module DM is folded, a center of curvature of the second curvable portion CP2 may be defined in an upper area of the display module DM, and centers of curvature of the first curvable portion CP1 and the third curvable portion CP3 may be defined in a lower area of the display module DM.

In case that the display device DD is folded, according to the stress of the second area AR2 of the display module DM, the first wing plate WPT1 may move to the first inclined surface SLP1 to be in contact with the first inclined surface SLP1, and the second wing plate WPT2 may move to the second inclined surface SLP2 to be in contact with the second inclined surface SLP2.

Due to the above-mentioned folding structure, in case that the display module DM is folded, a first gap GP1 between the first area AR1 and the third area AR3 may be smaller than a second gap GP2 between the first curvable portion CP1 and the third curvable portion CP3. The second gap GP2 may gradually increase as a distance from the second curvable portion CP2 decreases. Accordingly, in case that the display device DD is folded, the display module DM may be folded in a shape as illustrated in Fig. 8C.

In case that the display module DM is folded, the support frame CFM may move in a direction away from the display module DM. As shown in FIG. 8C, in case that the display device DD is completely folded, the display module DM may be spaced apart from the support frame CFM. For example, the display module DM may not interfere with the support frame CFM.

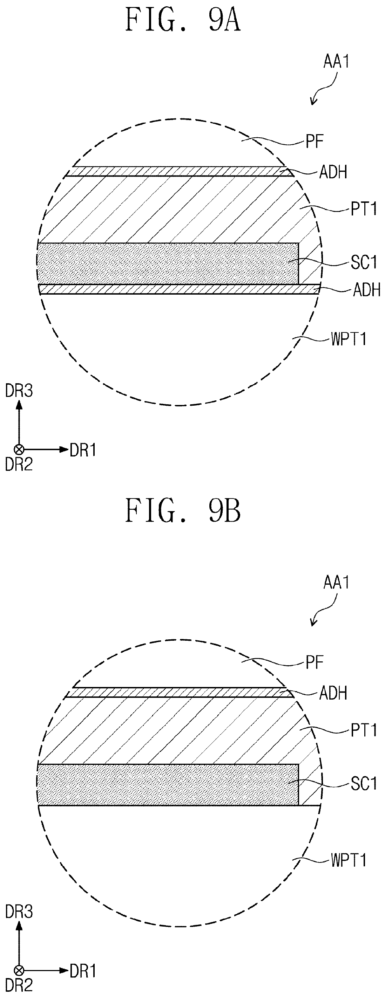

FIG. 9A is an enlarged cross-sectional view schematically showing portion AA1 shown in FIG. 8A according to an embodiment of the invention.

Referring to FIGS. 8A and 9A, an adhesive layer ADH may be disposed between the first plate PT1 and the first wing plate WPT1. Accordingly, the first plate PT1 may be coupled to the first wing plate WPT1. Although not shown in figures, the second plate PT2 (refer to FIG. 5) and the second wing plate WPT2 may be coupled to each other by an adhesive layer interposed therebetween.

FIG. 9B is an enlarged cross-sectional view schematically showing portion AA1 shown in FIG. 8A according to an embodiment of the invention.

Referring to FIGS. 8A and 9B, the first plate PT1 and the first wing plate WPT1 may face each other. In a case where the first compensation member SC1 may be silicon, the first plate PT1 may not be coupled to the first wing plate WPT1. In a case where the first compensation member SC1 may be an adhesive, the first plate PT1 and the first wing plate WPT1 may be coupled to each other by the first compensation member SC1. The above descriptions may be applied to the second plate PT2 (refer to FIG. 5), the second wing plate WPT2, and the second compensation member SC2 (refer to FIG. 5).

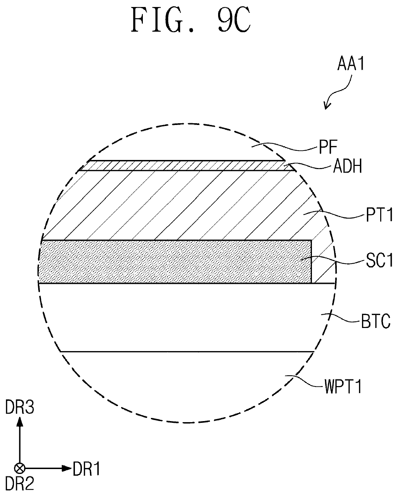

FIG. 9C is an enlarged cross-sectional view schematically showing portion AA1 shown in FIG. 8A according to an embodiment of the invention.

Referring to FIGS. 8A and 9C, lower members BTC may be further disposed between the first plate PT1 and the first wing plate WPT1. The lower members BTC may include an adhesive layer, an insulating layer, a heat dissipation layer, and a cushion layer, however, the lower members BTC should not be limited thereto or thereby. The lower members BTC may be attached to the first plate PT1. The first wing plate WPT1 may be attached to or may not be attached to the lower members BTC.

Although not shown in figures, the lower members BTC may be disposed between the second plate PT2 (refer to FIG. 5) and the second wing plate WPT2, and the above descriptions may be equally applied. The lower members BTC attached to the first plate PT1 may be spaced apart from the lower members attached to the second plate PT2 (refer to FIG. 5).

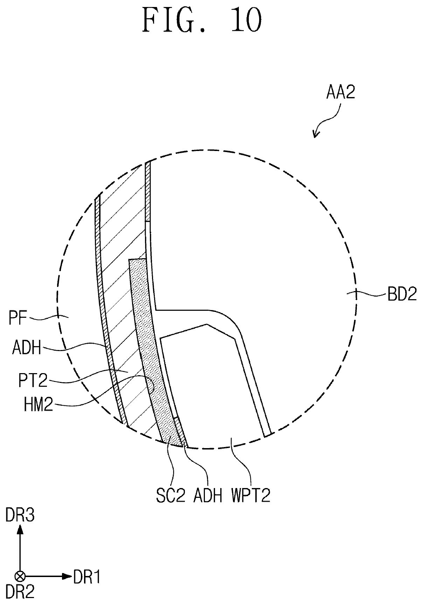

FIG. 10 is an enlarged cross-sectional view schematically showing portion AA2 shown in FIG. 8C according to an embodiment of the invention.

Referring to FIGS. 8C and 10, in case that the display device DD is folded, the second groove HM2 may be defined in the second plate PT2 corresponding to third curvable portion CP3. The second compensation member SC2 may be disposed in the second groove HM2. The second compensation member SC2 may have a more flexible property than the second plate PT2.

According to an embodiment of the invention, as the second groove HM2 may be defined in the second plate PT2 corresponding to the third curvable portion CP3, a thickness of the second plate PT2 may be reduced. As a result, in case that the display device DD is folded, the stress occurring in the second plate PT2 may be reduced. The second compensation member SC2 may be provided in the second groove HM2 of the second plate PT2. Accordingly, a portion of the display module DM corresponding to the second groove HM2 may be prevented from sagging downward.

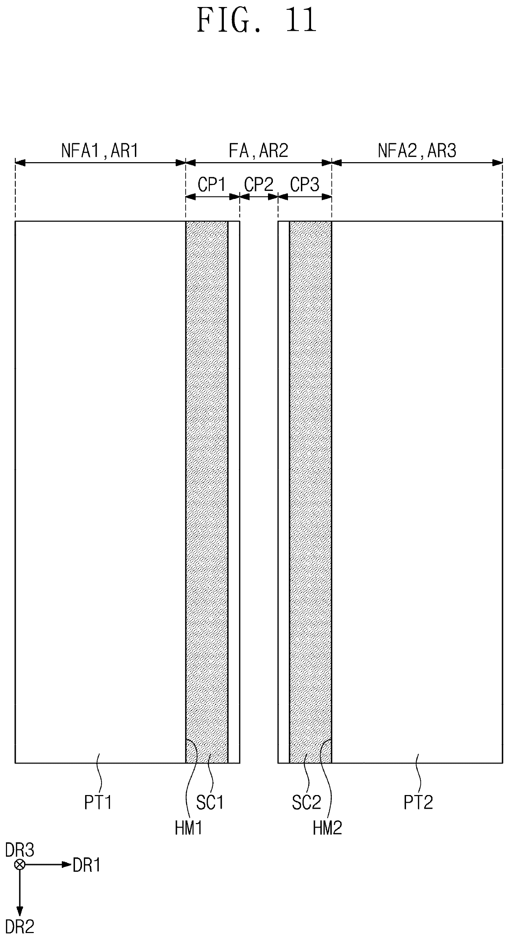

FIG. 11 is a rear view schematically showing the first plate PT1 and the second plate PT2 according to an embodiment of the invention.

Referring to FIGS. 5 and 11, the first plate PT1 and the second plate PT2 may be spaced apart from each other in the first direction DR1. For example, the gap between the first plate PT1 and the second plate PT2 may overlap the second curvable portion CP2 of the display panel DP. For example, since the first plate PT1 and the second plate PT2 may be completely separated from each other, the stress caused by the second curvable portion CP2 may not occur in the first plate PT1 and the second plate PT2. In case that the display device DD (refer to FIG. 1) is in the unfolded state or the flat state, the second curvable portion CP2 of the display panel DP may be supported by the support frame CFM described above. Accordingly, the portion corresponding to the second curvable portion CP2 of the display module DM may be prevented from sagging downward.

The first groove HM1 may be defined in a portion of the first plate PT1 overlapping the first curvable portion CP1, and the second groove HM2 may be defined in a portion of the second plate PT2 overlapping the third curvable portion CP3. Each of the first groove HM1 and the second groove HM2 may extend in the second direction DR2. In a plan view, each of the first groove HM1 and the second groove HM2 may have a bar shape.

A portion of the first plate PT1 in which the first groove HM1 may be defined and a portion of the second plate PT2 in which the second groove HM2 may be defined may have a thickness smaller than a thickness of another portion of each of the first plate PT1 and the second plate PT2. Accordingly, in case that the display device DD (refer to FIG. 1) is folded, the stress occurring in the portion of the first plate PT1 and the portion of the second plate PT2 may be reduced. As a result, cracks and plastic deformation may be prevented from occurring in the first plate PT1 and the second plate PT2.

The first compensation member SC1 and the second compensation member SC2 may be respectively filled in the first groove HM1 and the second groove HM2 to compensate for a step difference. Accordingly, the portions corresponding to the first curvable portion CP1 and the third curvable portion CP3 of the display module DM may be prevented from sagging downward by the first compensation member SC1 and the second compensation member SC2.

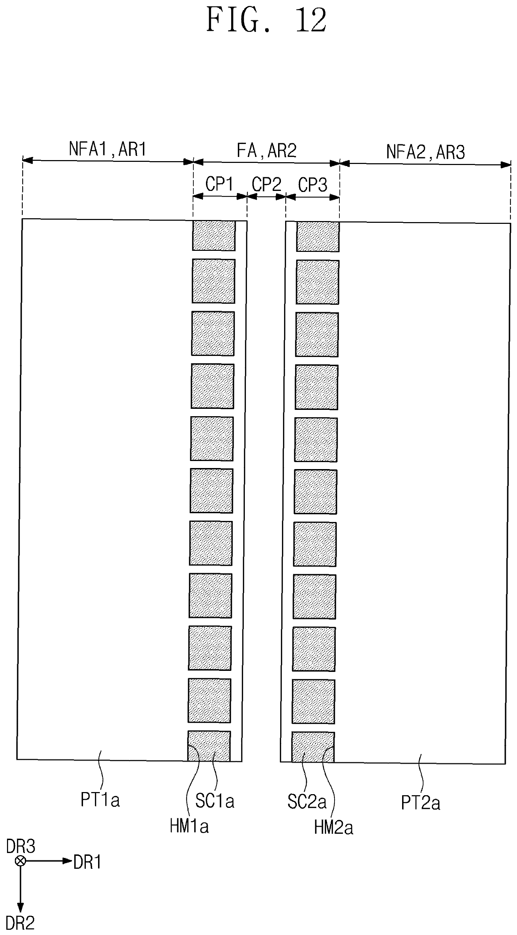

FIG. 12 is a rear view schematically showing a first plate PT1a and a second plate PT2a according to an embodiment of the invention.

Referring to FIGS. 5 and 12, the first plate PT1a and the second plate PT2a may be spaced apart from each other in the first direction DR1. For example, a gap between the first plate PT1a and the second plate PT2a may overlap the second curvable portion CP2 of the display panel DP. For example, as the first plate PT1a and the second plate PT2a may be completely separated from each other, the stress caused by the second curvable portion CP2 may not occur in the first plate PT1a and the second plate PT2a.

First grooves HM1a may be defined in a portion of the first plate PT1a overlapping the first curvable portion CP1, and second grooves HM2a may be defined in a portion of the second plate PT2a overlapping the third curvable portion CP3. The first grooves HM1a may be arranged in the second direction DR2, and the second grooves HM2a may be arranged in the second direction DR2.

First compensation members SC1a may be respectively filled in the first grooves HM1a to compensate for a step difference. Second compensation members SC2a may be respectively filled in the second grooves HM2a to compensate for a step difference. Accordingly, portions corresponding to the first curvable portion CP1 and the third curvable portion CP3 may be prevented from sagging downward by the first compensation members SC1a and the second compensation members SC2a.

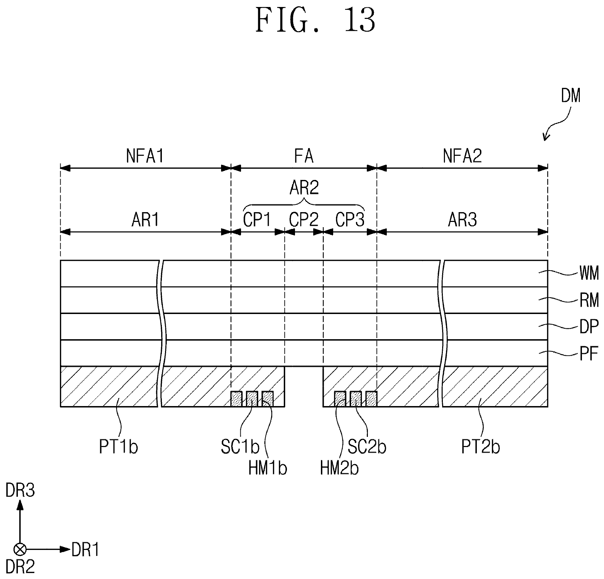

FIG. 13 is a cross-sectional view schematically showing a display module DM according to an embodiment of the invention. In FIG. 13, the same reference numerals denote the same elements in FIG. 5, and thus, detailed descriptions of the same elements will be omitted.

Referring to FIG. 13, the display module DM may include a window module WM, an anti-reflective layer RM, a display panel DP, a protective film PF, a first plate PT1b, and a second plate PT2b.

First grooves HM1b may be defined in the first plate PT1b, and second grooves HM2b may be defined in the second plate PT2b. Each of the first grooves HM1b and the second grooves HM2b may overlap a second area AR2.

A portion of the first plate PT1b in which the first grooves HM1b may be defined and a portion of the second plate PT2b in which the second grooves HM2b may be defined may have a thickness smaller than a thickness of another portion of each of the first plate PT1b and the second plate PT2b. Accordingly, in case that the display device DD (refer to FIG. 1) is folded, the stress occurring in the portion of the first plate PT1b and the portion of the second plate PT2b may be reduced. As a result, cracks and plastic deformation may be reduced or prevented from occurring in the first plate PT1b and the second plate PT2b.

First compensation members SC1b may be respectively disposed in the first grooves HM1b, and second compensation members SC2b may be respectively disposed in the second grooves HM2b. Since the first compensation members SC1b and the second compensation members SC2b may be respectively provided in the first grooves HM1b and the second grooves HM2b, the display panel DP may be prevented from sagging downward in the areas where the first grooves HM1b and the second grooves HM2b may be defined.

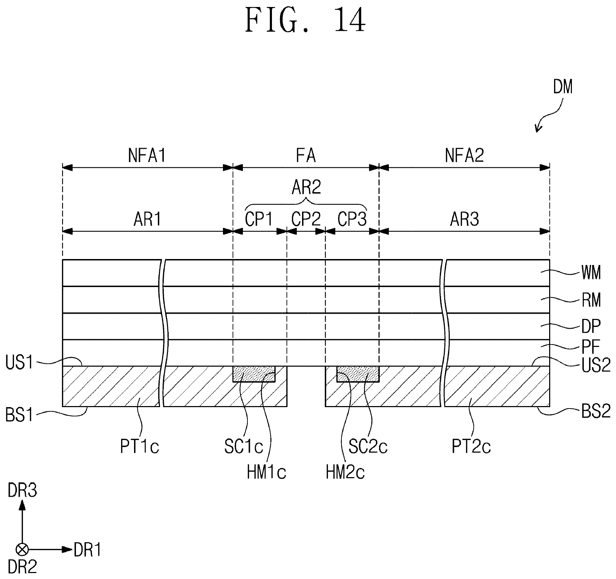

FIG. 14 is a cross-sectional view schematically showing a display module DM according to an embodiment of the invention. In FIG. 14, the same reference numerals denote the same elements in FIG. 5, and thus, detailed descriptions of the same elements will be omitted.

Referring to FIG. 14, the display module DM may include a window module WM, an anti-reflective layer RM, a display panel DP, a protective film PF, a first plate PT1c, and a second plate PT2c.

A first groove HM1c may be defined in the first plate PT1c, and a second groove HM2c may be defined in the second plate PT2c. Each of the first groove HM1c and the second groove HM2c may overlap a second area AR2. The first groove HM1c may be defined in a first upper surface US1, and the second groove HM2c may be defined in a second upper surface US2.

A first compensation member SC1c may be disposed in the first groove HM1c, and a second compensation member SC2c may be disposed in the second groove HM2c. As the first compensation member SC1c and the second compensation member SC2c may be respectively disposed in the first groove HM1c and the second groove HM2c, the display panel DP may be prevented from sagging downward in the areas where the first groove HM1c and the second groove HM2c may be defined.

Although embodiments of the invention have been described, it is understood that the invention should not be limited to these embodiments but various changes and modifications can be made by one ordinary skilled in the art within the scope of the invention as hereinafter claimed. Therefore, the disclosed subject matter should not be limited to any single embodiment described herein.

## Claims

1. A display device (DD) comprising:
a display panel (DP) comprising a first area (AR1), a second area (AR2), and a third area (AR3) that are sequentially defined in a first direction (DR1), the second area (AR2) being foldable;
a first plate (PT1) disposed under the display panel (DP) and overlapping the first area (AR1) and a portion of the second area (AR2), the first plate (PT1) is configured to be foldable with the display panel (DP) in the second area (AR2); and
a second plate (PT2) disposed under the display panel (DP) and overlapping the third area (AR3) and another portion of the second area (AR2), the second plate (PT2) is configured to be foldable with the display panel (DP) in the second area (AR2), wherein
the first plate (PT1) includes a first groove (HM1),
the second plate (PT2) includes a second groove (HM2), and
each of the first groove (HM1) and the second groove (HM2) overlaps the second area (AR2),
wherein
the first plate (PT1) comprises:
a first upper surface (US1);
a first lower surface (BS1) spaced apart from the display panel (DP), the first upper surface (US1) being disposed between the first lower surface (BS1) and the display panel (DP); and
a first side surface (SS1) extended to the first upper surface (US1) and the first lower surface (BS1) and facing the second plate (PT2), and
the second plate (PT2) comprises:
a second upper surface (US2);
a second lower surface (BS2) spaced apart from the display panel (DP), the second upper surface (US2) being disposed between the second lower surface (BS2) and the display panel (DP); and
a second side surface (SS2) extended to the second upper surface (US2) and the second lower surface (BS2) and facing the first plate (PT1)
wherein
the first groove (HM1) has a depth (DP1) smaller than a maximum distance (DT1) between the first upper surface (US1) and the first lower surface (BS1),
the second groove (HM2) has a depth (DP2) smaller than a maximum distance (DT2) between the second upper surface (US2) and the second lower surface (BS2), and
wherein the first groove (HM1) is spaced apart from the first side surface (SS1) and the second groove (HM2) is spaced apart from the second side surface (SS2).

2. The display device (DD) of claim 1, wherein each of the first groove (HM1) and the second groove (HM2) extends in a second direction (DR2) intersecting the first direction (DR1).

3. The display device (DD) of claim 1, wherein
the first groove (HM1) is defined in the first lower surface (BS1), and
the second groove (HM2) is defined in the second lower surface (BS2).

4. The display device (DD) of claim 1, wherein
the first groove (HM1) is defined in the first upper surface (US1), and
the second groove (HM2) is defined in the second upper surface (US2).

5. The display device (DD) of at least one of claims 1 to 4, further comprising:
a first compensation member (SC1) disposed in the first groove (HM1); and
a second compensation member (SC2) disposed in the second groove (HM2).

6. The display device (DD) of claim 5, wherein each of the first compensation member (SC1) and the second compensation member (SC2) has an elastic modulus smaller than an elastic modulus of each of the first plate (PT1) and the second plate (PT2).

7. The display device (DD) of at least one of claims 1 to 6, further comprising a folding set (FST) disposed under the first plate (PT1) and the second plate (PT2), wherein
the folding set (FST) comprises:
a first body (BD1) disposed under the first area (AR1);
a second body (BD2) disposed under the third area (AR3); and
a support frame (CFM) disposed under the second area (AR2),
the support frame (CFM) is disposed between the first plate (PT1) and the second plate (PT2) and supports a lower portion of the display panel (DP) in case that the second area (AR2) of the display panel (DP) is unfolded, and
the support frame (CFM) is spaced apart from the display panel (DP) in case that the display panel (DP) is folded.

8. The display device (DD) of claim 7, wherein the folding set (FST) further comprises:
a first wing plate (WPT1) rotatably coupled to the first body (BD1); and
a second wing plate (WPT2) rotatably coupled to the second body (BD2).

9. The display device (DD) of claim 8, wherein the support frame (CFM) comprises a portion (CFMP) having a width (WTG) smaller than a distance (DTW) in the first direction (DR1) between the first wing plate (WPT1) and the second wing plate (WPT2).

10. The display device (DD) of at least one of claims 1 to 9, wherein
a first curvable portion (CP1), a second curvable portion (CP2), and a third curvable portion (CP3) are defined in the second area (AR2),
the first curvable portion (CP1) and the third curvable portion (CP3) are spaced apart from each other, the second curvable portion (CP2) being disposed between the first curvable portion ortion (CP1) and the third curvable portion (CP3),
the first curvable portion (CP1) overlaps the first groove (HM1), and
the third curvable portion (CP3) overlaps the second groove (HM2).

11. The display device (DD) of claim 10, wherein the first curvable portion (CP1) and the third curvable portion (CP3) are curved in a direction opposite to a direction in which the second curvable portion (CP2) is curved.

12. The display device (DD) of claim 10 or 11, wherein the second curvable portion (CP2) overlaps a gap between the first plate (PT1) and the second plate (PT2).

## Patentansprüche

1. Eine Anzeigevorrichtung (DD), umfassend:
eine Anzeigeplatte (DP), umfassend einen ersten Bereich (AR1), einen zweiten Bereich (AR2) und einen dritten Bereich (AR3), die nacheinander in einer ersten Richtung (DR1) definiert sind, wobei der zweite Bereich (AR2) faltbar ist;
eine erste Platte (PT1), die unter der Anzeigeplatte (DP) angeordnet ist und den ersten Bereich (AR1) und einen Abschnitt des zweiten Bereichs (AR2) überlappt, wobei die erste Platte (PT1) dazu konfiguriert ist, mit der Anzeigeplatte (DP) in dem zweiten Bereich (AR2) faltbar zu sein; und
eine zweite Platte (PT2), die unter der Anzeigeplatte (DP) angeordnet ist und den dritten Bereich (AR3) und einen anderen Abschnitt des zweiten Bereichs (AR2) überlappt, wobei die zweite Platte (PT2) dazu konfiguriert ist, mit der Anzeigeplatte (DP) in dem zweiten Bereich (AR2) faltbar zu sein, wobei die erste Platte (PT1) eine erste Nut (HM1) einschließt,
die zweite Platte (PT2) eine zweite Nut (HM2) einschließt und jede der ersten Nut (HM1) und der zweiten Nut (HM2) den zweiten Bereich (AR2) überlappt,
wobei
die erste Platte (PT1) umfasst:
eine erste obere Oberfläche (US1);
eine erste untere Oberfläche (BS1), die von der Anzeigeplatte (DP) beabstandet ist, wobei die erste obere Oberfläche (US1) zwischen der ersten unteren Oberfläche (BS1) und der Anzeigeplatte (DP) angeordnet ist;
und eine erste Seitenoberfläche (SS1), die sich zu der ersten oberen Oberfläche (US1) und der ersten unteren Oberfläche (BS1) erstreckt und der zweiten Platte (PT2) zugewandt ist, und
wobei die zweite Platte (PT2) umfasst:
eine zweite obere Oberfläche (US2);
eine zweite untere Oberfläche (BS2), die von der Anzeigeplatte (DP) beabstandet ist, wobei die zweite obere Oberfläche (US2) zwischen der zweiten unteren Oberfläche (BS2) und der Anzeigeplatte (DP) angeordnet ist; und
eine zweite Seitenoberfläche (SS2), die sich zu der zweiten oberen Oberfläche (US2) und der zweiten unteren Oberfläche (BS2) erstreckt und der ersten Platte (PT1) zugewandt ist,
wobei
die erste Nut (HM1) eine Tiefe (DP1) aufweist, die kleiner als ein maximaler Abstand (DT1) zwischen der ersten oberen Oberfläche (US1) und der ersten unteren Oberfläche (BS1) ist,
die zweite Nut (HM2) eine Tiefe (DP2) aufweist, die kleiner als ein maximaler Abstand (DT2) zwischen der zweiten oberen Oberfläche (US2) und der zweiten unteren Oberfläche (BS2) ist, und
wobei die erste Nut (HM1) von der ersten Seitenoberfläche (SS1) beabstandet ist und die zweite Nut (HM2) von der zweiten Seitenoberfläche (SS2) beabstandet ist.

2. Die Anzeigevorrichtung (DD) nach Anspruch 1, wobei sich jede der ersten Nut (HM1) und der zweiten Nut (HM2) in einer zweiten Richtung (DR2) erstreckt, die die erste Richtung (DR1) schneidet.

3. Die Anzeigevorrichtung (DD) nach Anspruch 1, wobei die erste Nut (HM1) in der ersten unteren Oberfläche (BS1) definiert ist und die zweite Nut (HM2) in der zweiten unteren Oberfläche (BS2) definiert ist.

4. Die Anzeigevorrichtung (DD) nach Anspruch 1, wobei die erste Nut (HM1) in der ersten oberen Oberfläche (US1) definiert ist und die zweite Nut (HM2) in der zweiten oberen Oberfläche (US2) definiert ist.

5. Die Anzeigevorrichtung (DD) nach mindestens einem der Ansprüche 1 bis 4, ferner umfassend:
ein erstes Kompensationselement (SC1), das in der ersten Nut (HM1) angeordnet ist; und
ein zweites Kompensationselement (SC2), das in der zweiten Nut (HM2) angeordnet ist.

6. Die Anzeigevorrichtung (DD) nach Anspruch 5, wobei jedes des ersten Kompensationselements (SC1) und des zweiten Kompensationselements (SC2) einen Elastizitätsmodul aufweist, der kleiner als ein Elastizitätsmodul jedes der ersten Platte (PT1) und der zweiten Platte (PT2) ist.

7. Die Anzeigevorrichtung (DD) nach mindestens einem der Ansprüche 1 bis 6, ferner umfassend einen Falt-Satz (FST), der unter der ersten Platte (PT1) und der zweiten Platte (PT2) angeordnet ist, wobei
der Falt-Satz (FST) umfasst:
einen ersten Körper (BD1), der unter dem ersten Bereich (AR1) angeordnet ist;
einen zweiten Körper (BD2), der unter dem dritten Bereich (AR3) angeordnet ist; und
einen Stützrahmen (CFM), der unter dem zweiten Bereich (AR2) angeordnet ist, wobei der Stützrahmen (CFM) zwischen der ersten Platte (PT1) und der zweiten Platte (PT2) angeordnet ist und einen unteren Abschnitt der Anzeigeplatte (DP) für den Fall, dass der zweite Bereich (AR2) der Anzeigeplatte (DP) entfaltet ist, stützt, und
der Stützrahmen (CFM) von der Anzeigeplatte (DP) für den Fall, dass die Anzeigeplatte (DP) gefaltet ist, beabstandet ist.

8. Die Anzeigevorrichtung (DD) nach Anspruch 7, wobei der Falt-Satz (FST) ferner umfasst:
eine erste Flügelplatte (WPT1), die drehbar mit dem ersten Körper (BD1) gekoppelt ist; und
eine zweite Flügelplatte (WPT2), die drehbar mit dem zweiten Körper (BD2) gekoppelt ist.

9. Die Anzeigevorrichtung (DD) nach Anspruch 8, wobei der Stützrahmen (CFM) einen Abschnitt (CFMP) umfasst, der eine Breite (WTG) aufweist, die kleiner als ein Abstand (DTW) in der ersten Richtung (DR1) zwischen der ersten Flügelplatte (WPT1) und der zweiten Flügelplatte (WPT2) ist.

10. Die Anzeigevorrichtung (DD) nach mindestens einem der Ansprüche 1 bis 9, wobei
ein erster biegbarer Abschnitt (CP1), ein zweiter biegbarer Abschnitt (CP2) und ein dritter biegbarer Abschnitt (CP3) in dem zweiten Bereich (AR2) definiert sind, wobei der erste biegbare Abschnitt (CP1) und der dritte biegbare Abschnitt (CP3) voneinander beabstandet sind, wobei der zweite biegbare Abschnitt (CP2) zwischen dem ersten biegbaren Abschnitt (CP1) und dem dritten biegbaren Abschnitt (CP3) angeordnet ist,
wobei der erste biegbare Abschnitt (CP1) die erste Nut (HM1) überlappt und der dritte biegbare Abschnitt (CP3) die zweite Nut (HM2) überlappt.

11. Die Anzeigevorrichtung (DD) nach Anspruch 10, wobei der erste biegbare Abschnitt (CP1) und der dritte biegbare Abschnitt (CP3) in einer Richtung gekrümmt sind, die einer Richtung entgegengesetzt ist, in der der zweite biegbare Abschnitt (CP2) gekrümmt ist.

12. Die Anzeigevorrichtung (DD) nach Anspruch 10 oder 11, wobei der zweite biegbare Abschnitt (CP2) einen Spalt zwischen der ersten Platte (PT1) und der zweiten Platte (PT2) überlappt.

## Revendications

1. Dispositif d'affichage (DD) comprenant :
un panneau d'affichage (DP) comprenant une première zone (AR1), une deuxième zone (AR2) et une troisième zone (AR3) qui sont définies en séquence dans une première direction (DR1), la deuxième zone (AR2) étant pliable ;
une première plaque (PT1) disposée sous le panneau d'affichage (DP) et chevauchant la première zone (AR1) et une partie de la deuxième zone (AR2), la première plaque (PT1) est configurée pour être pliable avec le panneau d'affichage (DP) dans la deuxième zone (AR2) ; et
une deuxième plaque (PT2) disposée sous le panneau d'affichage (DP) et chevauchant la troisième zone (AR3) et une autre partie de la deuxième zone (AR2), la deuxième plaque (PT2) est configurée pour être pliable avec le panneau d'affichage (DP) dans la deuxième zone (AR2), dans lequel
la première plaque (PT1) comporte une première rainure (HM1),
la deuxième plaque (PT2) comporte une deuxième rainure (HM2), et
chacune de la première rainure (HM1) et de la deuxième rainure (HM2) chevauche la deuxième zone (AR2),
dans lequel
la première plaque (PT1) comprend :
une première surface supérieure (US1) ;
une première surface inférieure (BS1) espacée du panneau d'affichage (DP), la première surface supérieure (US1) étant disposée entre la première surface inférieure (BS1) et le panneau d'affichage (DP) ; et
une première surface latérale (SS1) s'étendant jusqu'à la première surface supérieure (US1) et la première surface inférieure (BS1) et faisant face à la deuxième plaque (PT2), et
la deuxième plaque (PT2) comprend :
une deuxième surface supérieure (US2) ;
une deuxième surface inférieure (BS2) espacée du panneau d'affichage (DP), la deuxième surface supérieure (US2) étant disposée entre la deuxième surface inférieure (BS2) et le panneau d'affichage (DP) ; et
une deuxième surface latérale (SS2) s'étendant jusqu'à la deuxième surface supérieure (US2) et la deuxième surface inférieure (BS2) et faisant face à la première plaque (PT1),
dans lequel
la première rainure (HM1) présente une profondeur (DP1) plus petite qu'une distance maximale (DT1) entre la première surface supérieure (US1) et la première surface inférieure (BS1),
la deuxième rainure (HM2) présente une profondeur (DP2) plus petite qu'une distance maximale (DT2) entre la deuxième surface supérieure (US2) et la deuxième surface inférieure (BS2), et
dans lequel la première rainure (HM1) est espacée de la première surface latérale (SS1) et la deuxième rainure (HM2) est espacée de la deuxième surface latérale (SS2).

2. Dispositif d'affichage (DD) selon la revendication 1, dans lequel chacune de la première rainure (HM1) et de la deuxième rainure (HM2) s'étend dans une deuxième direction (DR2) intersectant la première direction (DR1).

3. Dispositif d'affichage (DD) selon la revendication 1, dans lequel
la première rainure (HM1) est définie dans la première surface inférieure (BS1), et la deuxième rainure (HM2) est définie dans la deuxième surface inférieure (BS2).

4. Dispositif d'affichage (DD) selon la revendication 1, dans lequel
la première rainure (HM1) est définie dans la première surface supérieure (US1), et
la deuxième rainure (HM2) est définie dans la deuxième surface supérieure (US2).

5. Dispositif d'affichage (DD) selon au moins l'une des revendications 1 à 4, comprenant en outre :
un premier élément de compensation (SC1) disposé dans la première rainure (HM1) ; et
un deuxième élément de compensation (SC2) disposé dans la deuxième rainure (HM2).

6. Dispositif d'affichage (DD) selon la revendication 5, dans lequel chacun du premier élément de compensation (SC1) et du deuxième élément de compensation (SC2) présente un module d'élasticité inférieur à un module d'élasticité de chacune de la première plaque (PT1) et de la deuxième plaque (PT2).

7. Dispositif d'affichage (DD) selon au moins l'une des revendications 1 à 6, comprenant en outre un ensemble pliable (FST) disposé sous la première plaque (PT1) et la deuxième plaque (PT2), dans lequel
l'ensemble pliable (FST) comprend :
un premier corps (BD1) disposé sous la première zone (AR1) ;
un deuxième corps (BD2) disposé sous la troisième zone (AR3) ; et
un cadre de support (CFM) disposé sous la deuxième zone (AR2),
le cadre de support (CFM) est disposé entre la première plaque (PT1) et la deuxième plaque (PT2) et soutient une partie inférieure du panneau d'affichage (DP) dans le cas où la deuxième zone (AR2) du panneau d'affichage (DP) est dépliée, et
le cadre de support (CFM) est espacé du panneau d'affichage (DP) dans le cas où le panneau d'affichage (DP) est plié.

8. Dispositif d'affichage (DD) selon la revendication 7, dans lequel l'ensemble pliable (FST) comprend en outre :
une première plaque d'aile (WPT1) couplée de manière rotative au premier corps (BD1) ; et
une deuxième plaque d'aile (WPT2) couplée de manière rotative au deuxième corps (BD2).

9. Dispositif d'affichage (DD) selon la revendication 8, dans lequel le cadre de support (CFM) comprend une partie (CFMP) présentant une largeur (WTG) plus petite qu'une distance (DTW) dans la première direction (DR1) entre la première plaque d'aile (WPT1) et la deuxième plaque d'aile (WPT2).

10. Dispositif d'affichage (DD) selon au moins l'une des revendications 1 à 9, dans lequel
une première partie courbable (CP1), une deuxième partie courbable (CP2) et une troisième partie courbable (CP3) sont définies dans la deuxième zone (AR2), la première partie courbable (CP1) et la troisième partie courbable (CP3) sont espacées l'une de l'autre, la deuxième partie courbable (CP2) étant disposée entre la première partie courbable (CP1) et la troisième partie courbable (CP3), la première partie courbable (CP1) chevauche la première rainure (HM1), et
la troisième partie courbable (CP3) chevauche la deuxième rainure (HM2).

11. Dispositif d'affichage (DD) selon la revendication 10, dans lequel la première partie courbable (CP1) et la troisième partie courbable (CP3) sont courbées dans une direction opposée à une direction dans laquelle la deuxième partie courbable (CP2) est courbée.

12. Dispositif d'affichage (DD) selon la revendication 10 ou 11, dans lequel la deuxième partie courbable (CP2) chevauche un espace entre la première plaque (PT1) et la deuxième plaque (PT2).
